(19) Europäisches Patentamt
European Patent Office
Office européen des brevets

(11) Publication number: **0 431 444 A2**

(12) **EUROPEAN PATENT APPLICATION**

(21) Application number: **90122648.0**

(22) Date of filing: **27.11.90**

(51) Int. Cl.[5]: **H01L 21/225**, H01L 21/3215, H01L 21/336, H01L 29/784

(30) Priority: **06.12.89 JP 318560/89**

(43) Date of publication of application: **12.06.91 Bulletin 91/24**

(84) Designated Contracting States: **DE FR GB**

(71) Applicant: **SEIKO INSTRUMENTS INC.**
**31-1, Kameido 6-chome Koto-ku**
**Tokyo 136(JP)**

(72) Inventor: **Akamine, Tadao, c/o Seiko Instruments Inc.**
**31-1, Kameido 6-chome**
**Koto-ku, Tokyo(JP)**
Inventor: **Aoki, Kenji, c/o Seiko Instruments Inc.**
**31-1, Kameido 6-chome**
**Koto-ku, Tokyo(JP)**

(74) Representative: **Fleuchaus, Leo, Dipl.-Ing. et al**
**Melchiorstrasse 42**
**W-8000 München 71(DE)**

(54) **Method of producing MIS transistor having gate electrode of matched conductivity type.**

(57) The method of producing an MIS transistor. There is prepared a substrate formed with a gate electrode and a semiconductor layer which defines a source region and a drain region. A natural oxide film is removed from a surface of the gate electrode and from a surface of the semiconductor layer to expose an active surface. A source gas containing an impurity component is applied to the exposed active surface to deposit thereon an impurity adsorption film. The substrate is annealed to diffuse the impurity component from the impurity adsorption film into the gate electrode and concurrently into the semiconductor layer to form the source and drain regions. The gate electrode has the same conductivity type as that of the source and drain regions.

EP 0 431 444 A2

# METHOD OF PRODUCING MIS TRANSISTOR HAVING GATE ELECTRODE OF MATCHED CONDUCTIVITY TYPE

## BACKGROUND OF THE INVENTION

The present invention relates to the method of producing an MIS transistor having a gate electrode of the same conductivity type as that of source and drain regions of the transistor. Hereinafter, such gate electrode is referred to as "matched conductivity type".

Conventionally when producing the MIS transistor having the gate electrode of matched conductivity type, ion implantation method or predeposition method is utilized to dope the same conductivity type of impurity into the gate electrode and the source and drain regions.

However, the conventional doping methods have various drawbacks. With regard to the ion implantation method, the impurity particles are implanted into a certain depth due to kinetic energy of accelerated impurity ion particles. Therefore, when activation of the ion particles is carried out by thermal treatment after the ion implantation, the impurity particles are diffused from the gate electrode to a gate insulating film and further to a channel region.

With regard to the predeposition method, since the impurity is diffused through an oxide film, the impurity density cannot be controlled well. Further in view of relatively high temperature processing at about 900°C, impurity particles may be diffused from the gate electrode into the channel region similarly as in case of the ion implantation.

As noted above, when the conventional methods such as ion implantation and predeposition are utilized to effect the impurity doping to a gate electrode of the matched conductivity type of the MIS transistor, the impurity particles having one conductivity type opposite to that of the channel region are inadvertently diffused from the gate electrode into the channel region disposed under the gate electrode, thereby causing drawbacks such as shift of threshold voltage of the transistor, and reduction of carrier mobility due to excess density of impurity atoms in the channel region. Such drawbacks are most serious in the P channel MIS transistor having the matched conductivity type of gate electrode which contains P type impurity of boron (B) which has relatively great diffusion coefficient.

## SUMMARY OF THE INVENTION

In view of the above noted drawbacks of the prior art, an object of the present invention is to provide a new method of doping an impurity limitatively only into a shallow surface portion of the matched conductivity type gate electrode so as to avoid diffusion of the impurity into the channel region.

According to the invention, an active surface is exposed on a surface of a gate electrode and on a patterned surface area of a semiconductor layer. Then, a gas containing an impurity component is applied to the exposed active surface to deposit thereon an adsorption film containing the impurity component. Thereafter, thermal treatment is effected to diffuse the impurity component concurrently into the gate electrode and into the patterned surface area to form a pair of source and drain regions in the semiconductor layer by solid-phase diffusion. The above new doping method is hereinafter referred to as "Molecular Layer Doping (MLD)". By using the MLD, an MIS transistor can be formed with a gate electrode having the same conductivity type as that of the source and drain regions.

## BRIEF DESCRIPTION OF THE DRAWINGS

Figs. IA - ID are a step diagram showing the inventive method of producing an MIS transistor having a gate electrode of the matched conductivity type;

Fig. 2 is a block diagram showing an impurity doping apparatus;

Figs. 3A - 3D are a step diagram showing a variation of the inventive method; and

Fig. 4 is a diagram showing an impurity distribution in a channel region under the gate electrode.

## DETAILED DESCRIPTION OF THE INVENTION

Figs. IA - ID are a step diagram showing a typical method of producing an MIS transistor having a gate electrode of the matched conductivity type according to the invention. This embodiment is directed to the production of a P channel transistor in which a P type impurity, for example boron, is doped into a device region. In the Fig. IA step, there is provided a semiconductor substrate I composed of silicon. A field oxide film 2 is formed on a surface of the substrate I to define a device isolation region. The field oxide film 2 is formed by selective thermal oxidation treatment to surround a device region. A gate insulating film 3 and a gate electrode 4 are formed in the device region. The gate insulating film 3 is composed of silicon oxide layer, silicon nitride layer or a double layer of silicon oxide film and silicon nitride film. The gate electrode 4 is composed of polysilicon which is deposited by, for example, chemical vapor deposition and then patterned in a predetermined shape. The original gate insulating film 3 is partly etched away through a mask of the patterned gate electrode 4 concurrently at the patterning of the gate electrode 4 or after the patterning so as to form a window portion. The thus prepared device region is covered with a natural oxide film 5.

In the Fig. lB step, activation treatment or cleaning treatment is applied to a surface of the device region to remove the natural oxide film 5. For example, hydrogen gas($H_2$) is introduced for five minutes into a vacuum chamber held at less than l x $10^{-4}$ Pa of the background pressure while heating the substrate l at 850°C in the chamber, so that the chamber pressure is raised to l.3 × $10^{-2}$ Pa. Consequently, an active surface is exposed on the gate electrode 4 and on the window portion of the semiconductor layer not covered by the gate insulating film 3 within the device region.

In the Fig. lC step, diborane gas($B_2H_6$) 9 is introduced at l × $10^{-3}$ Pa for l00 seconds while heating the substrate l at 825°C so as to deposit an impurity adsorption film 6 on the exposed aotive surface over the gate electrode and the window portion of the semiconductor substrate. The impurity adsorption film 6 contains boron atoms produced by thermal dissociation of the diborane gas 9.

Lastly in the Fig. lD step, annealing is effected such that the impurity boron contained in the adsorption film 6 is diffused into the gate electrode 4 by solid-phase diffusion to optimumly set electroconductance of the gate electrode 4. Concurrently, the impurity boron is diffused into the substrate l through the window portion to form source region 7 and drain region 8, which contain significant amount of the P type impurity of boron. The diffusion density and diffusion depth of the source region 7 and drain region 8 may depend on the amount of impurity boron contained in the adsorption film 6 and on the annealing condition. The amount of impurity boron can be controlled quite accurately by regulating charging pressure and charging time interval of the diborane gas 9 and the substrate temperature during the charging of the diborane gas.

In the above described embodiment, the impurity components are distributed at relatively high concentration in the surface or outer portion of the gate electrode and at relatively low concentration in the inner portion of the gate electrode. Therefore, the amount of impurity diffused from the gate electrode 4 into the channel region through the gate insulating film 3 can be reduced.

Next, the description is given for an apparatus utilized for carrying out the inventive impurity doping method or MLD with reference to Fig. 2. As shown in the figure, the impurity doping apparatus is comprised of a vacuum chamber l2 made of quartz, in which is placed centrally a silicon substrate l. A heating unit l3 is provided to controllably heat the substrate l to set a desired substrate temperature by an infrared lamp heating or resistance heating. The interior of vacuum chamber l2 can be evacuated in high vacuum degree by a high vacuum evacuation system l4 comprised of plural pumps including a main vacuum pump composed of a turbo molecular pump. A pressure gage l5 is utilized to continuously monitor the vacuum degree of the chamber l2. A transportation mechanism l8 is utilized to transport the silicon substrate l to the chamber l2 from a load chamber l7 through a gate valve l6a which is held open during the transportation. The load chamber l7 is normally evacuated by another evacuation system ll while a gate valve l6b is held open except during the supply of substrates to the load chamber l7 and during the transportation of each substrate from the load chamber l7. A gas supply source l9 is connected to the vacuum chamber l2 through a gas flow control system 20. The gas supply source l9 contains a plurality of bottles for storing various gas species needed to carry out the inventive impurity doping. The gas flow control system 20 is operated to control gas species, gas charging time and gas charging pressure.

Next, the description is given for the operation of the Fig. 2 apparatus to effect the inventive impurity doping. When doping impurity into a gate electrode and a pair of source and drain regions of an MIS transistor to establish the same conductivity type, activation treatment or cleaning treatment is applied to a surface of the gate electrode and a surface of a device region not covered by an gate insulating film. Namely, the silicon substrate l is placed in a center of the vacuum chamber l2 held at less than l × $10^{-4}$ Pa of the background pressure. Then, hydrogen gas is introduced into the chamber l2 from the gas supply source l9 while maintaining a temperature of the substrate l at, for example, 850°C. The hydrogen gas is filled in the chamber l2 for a predetermined time interval at the condition of l.3 x $10^{-2}$ Pa of the chamber pressure. By this treatment, an inert film, i.e., natural oxide film is removed from the gate electrode surface and from the surface of device region not covered by the gate insulating film, thereby exposing a chemically active silicon surface. This activation treatment is important for preparation of the following adsorption treatment. Namely, the adsorption film is selectively deposited only on the active silicon surface.

Subsequently, the adsorption treatment is carried out by charging a source gas into the chamber l2. The substrate l is heated at a temperature in the range from 400°C to 900°C. The source gas is composed of a gaseous compound containing an impurity component of P or N type. For example, diborane gas($B_2H_6$) containing P type impurity component of boron is introduced into the chamber to form the adsorption film containing boron.

Lastly, the substrate l is annealed for a predetermined time interval to effect diffusion of the impurity boron from a diffusion source of the adsorption film 6. The diffused impurity of boron is activated concurrently.

As described above, when forming the gate electrode and the source and drain regions according to the inventive impurity doping method, the impurity components are directly deposited on the active surface of the semiconductor material without an intermediate oxide film. Therefore, the impurity dose can be accurately controlled as compared to the conventional predeposition. Since the impurity is diffused internally by annealing treatment after adsorbing the impurity on the active surface, a quite shallow junction can be formed as compared to the conventional ion implantation by which an impurity particle is initially injected in a certain depth.

Figs. 3A - 3D are a step diagram showing a variation of the inventive method of producing the MIS transistor. In the Fig. 3A step, there is prepared a semiconductor substrate l composed of silicon. A field oxide film 2 is formed on a surface of the substrate l. A gate insulating film 3 and a gate electrode 4 are formed in a device region. A side wall l0 is formed around the gate electrode 4. The side wall l0 is provided by anisotropic etching a thick silicon oxide film deposited on the patterned gate electrode 4 by CVD. The side wall l0 has a thickness smaller than an expected value of horizontal diffusion span. After or during forming the side wall l0, the thick oxide film is removed by dry etching or wet etching from a top surface of the gate electrode 4 and from a window portion extending between the side wall l0 and the field oxide film 2. However, a thin natural oxide film 5 may be formed on the top surface of the gate electrode 4 and on the window portion immediately after removing the thick oxide film.

In the Fig. 3B step, the natural oxide film 5 is removed by activation treatment in manner similar to the Fig. lB step of the previous embodiment. Consequently, a silicon active surface is exposed on the top surface of the gate electrode 4 and on the window portion existing between the edge of the gate insulating film 3 or side wall l0 and the edge of the field oxide film 2.

In the Fig. 3C step, a diborane gas 9 is introduced in manner similar to the Fig. lC step of the previous embodiment. Consequently, an impurity adsorption film 6 is deposited on the top surface of the gate electrode 4 which is not covered by the side wall l0 and on the exposed window portion.

Lastly in the Fig. 3D step, annealing treatment is carried out so that the impurity boron contained in the impurity adsorption film 6 is diffused into the gate electrode 4 by solid-phase diffusion to optimumly set electric conductance of the gate electrode.
Concurrently, the impurity is diffused into the window portion to form a source region 7 and a drain region 8, having significant amount of the P type dopants. The source region 7 and the drain region 8 are formed such that their PN junction portions extends under the gate electrode 4 in order to avoid offset. For this, annealing temperature and time is optimumly set so that the impurity atoms diffuse horizontally from the impurity adsorption film 6 through a diffusion distance which exceeds the thickness of the side wall l0. For example, the substrate l is annealed at 850°C for thirty minutes so that the diffusion region extends horizontally by about 0.l $\mu$m.

In the above described embodiment, the gate electrode 4 has the same conductivity type as that of the source region 7 and drain region 8. Since the gate electrode 4 is surrounded by the side wall l0 along its side edge, the impurity adsorption film 6 is deposited only on the top surface of the gate electrode.
Accordingly, after annealing treatment for diffusion and activation of the impurity atoms, the impurity atoms are distributed at relatively high concentration in the upper section of the gate electrode 4 and at relatively low concentration in the lower section thereof in the vicinity of the gate insulating film 3. Therefore, the amount of the diffused impurities is further reduced, as compared to the previous embodiment, from the gate electrode to the cannel region.

In the above described embodiment, the diborane gas is utilized to dope a P type impurity into a silicon layer. However, there can be utilized other compound gas species of III-group elements such as trimethyl gallium (THG) and boron trichloride ($BCl_3$). On the other hand, doping of N type impurity to the silicon layer is effected by various gas compound species of V-group elements, such as arsine($AsH_3$), phosphorus trichloride($PCl_3$), antimony pentachloride($SbCl_5$) and phosphine($PH_3$).

A typical substrate temperature is set for the cleaning treatment, adsorption treatment and diffusion treatment in the above described embodiments. Generally, the substrate temperature may be optimumly set in the range from 800°C to l200°C for the surface cleaning or activation treatment in conjunction with the level of background pressure and ambient gas species. However, it should be noted that the cleaning treatment can be effected by other ways such as application of HF gas or irradiation of ultraviolet ray, effective to remove a natural oxide film. The substrate temperature is generally set optimumly in the range from 400 ° C to 950 ° C for the adsorption treatment. The substrate temperature for the diffusion treatment may be preferably set in the range comparable to that of the adsorption treatment. Annealing after the adsorption of the impurity can be effected by rapid thermal annealing using IR rump, laser beam annealing or plasma annealing so as to form further shallow diffusion depth in the source region 7 and the drain region 8.

As described above, according to the invention, the gate electrode and the pair of source and drain regions are concurrently doped with the same conductivity type of impurity. The doped impurity atoms are distributed at relatively high concentration in the upper section of the gate electrode and at relatively low concentration in the vicinity of the gate insulating film in contrast to the conventional ion implantation and predeposition technology, thereby efficiently suppressing undesired diffusion of the impurity from the gate electrode into the channel region as shown in the Fig. 4 graph. Therefore, the inventive method can effectively avoid shift of transistor threshold voltage and avoid reduction of the carrier mobility due to increase of the impurity in the channel region.

## Claims

**1.** A method of producing an MIS transistor, comprising:

first step of preparing a substrate formed with a gate electrode and a semiconductor layer which defines a source region and a drain region;

second step of removing an natural oxide film from a surface of the gate electrode and from a surface of the semiconductor layer to expose an active surface;

third step of applying a gas containing an impurity component to the active surface to form an adsorption film containing the impurity component; and

fourth step of annealing the substrate to diffuse the impurity component from the adsorption film into the gate electrode and into the semiconductor layer to form the source and drain regions so that the gate electrode has the same conductivity type as that of the source and drain regions.

**2.** A method according to claim l; wherein the first step includes forming a side wall to surround an edge portion of the gate electrode.

**3.** A method according to claim l; wherein the third step comprises applying a diborane gas containing an impurity component of boron to form an adsorption film composed of boron.

FIG. 1A

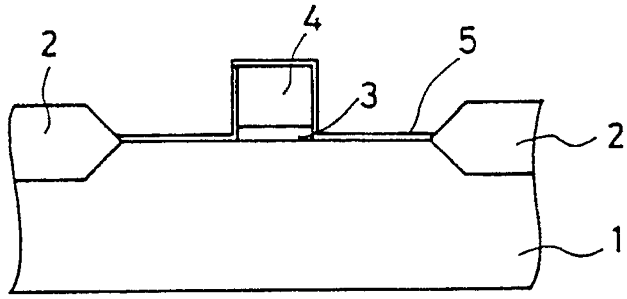


FIG. 1B

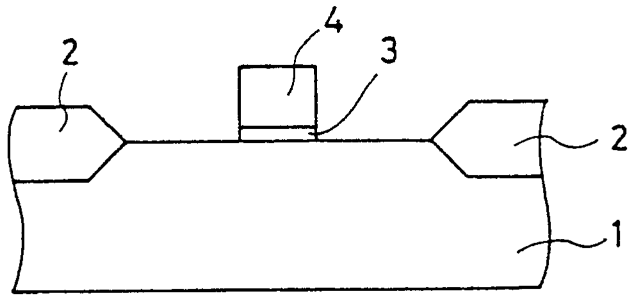


FIG. 1C

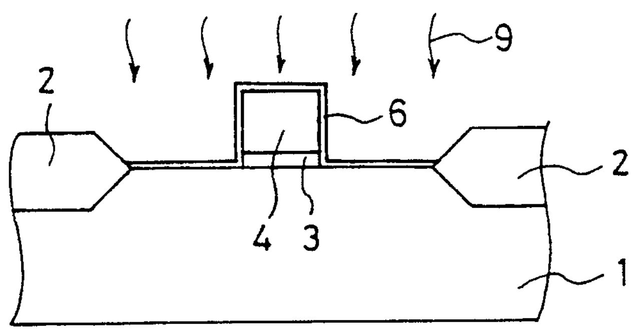


FIG. 1D

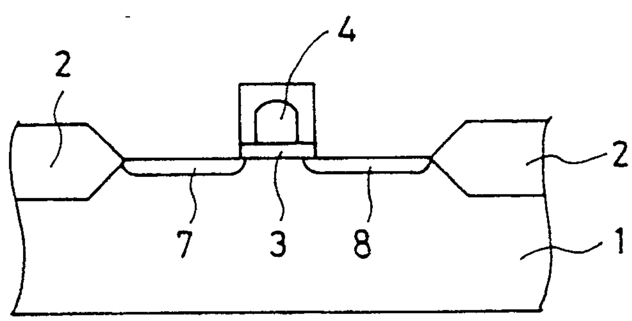

FIG. 2

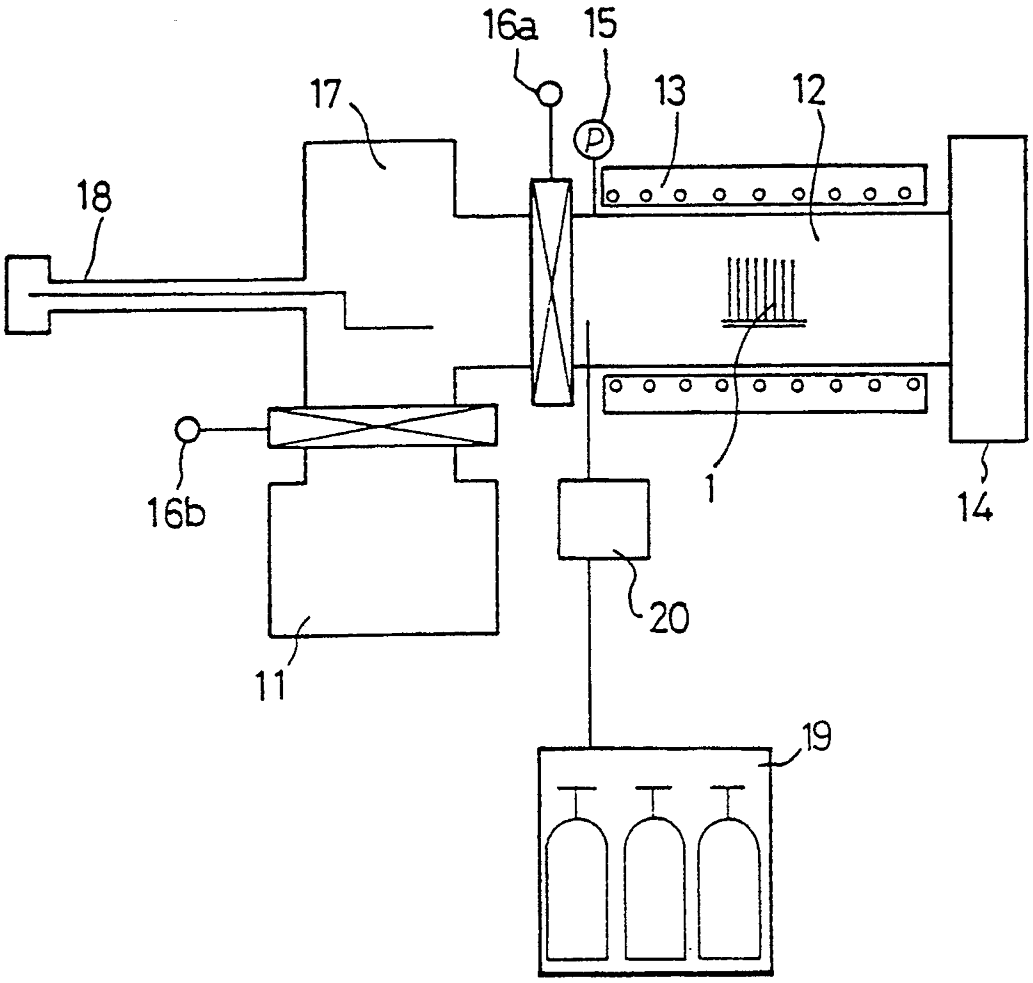

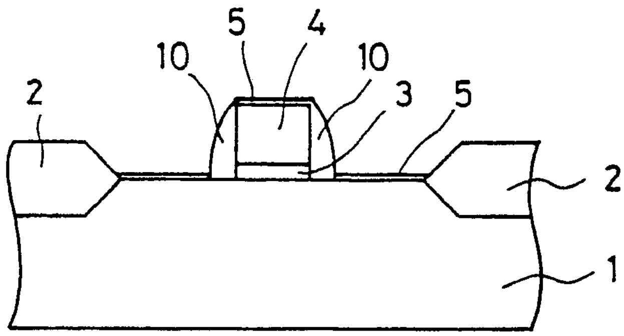


FIG. 3A

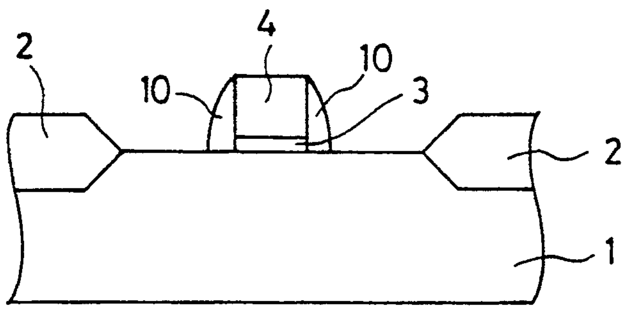


FIG. 3B

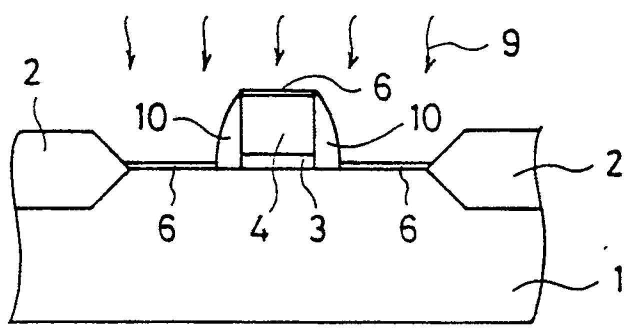


FIG. 3C

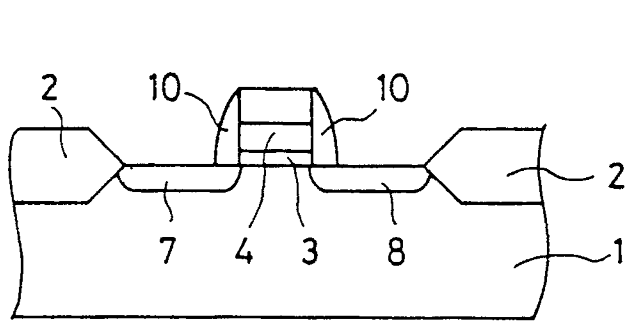


FIG. 3D

FIG. 4

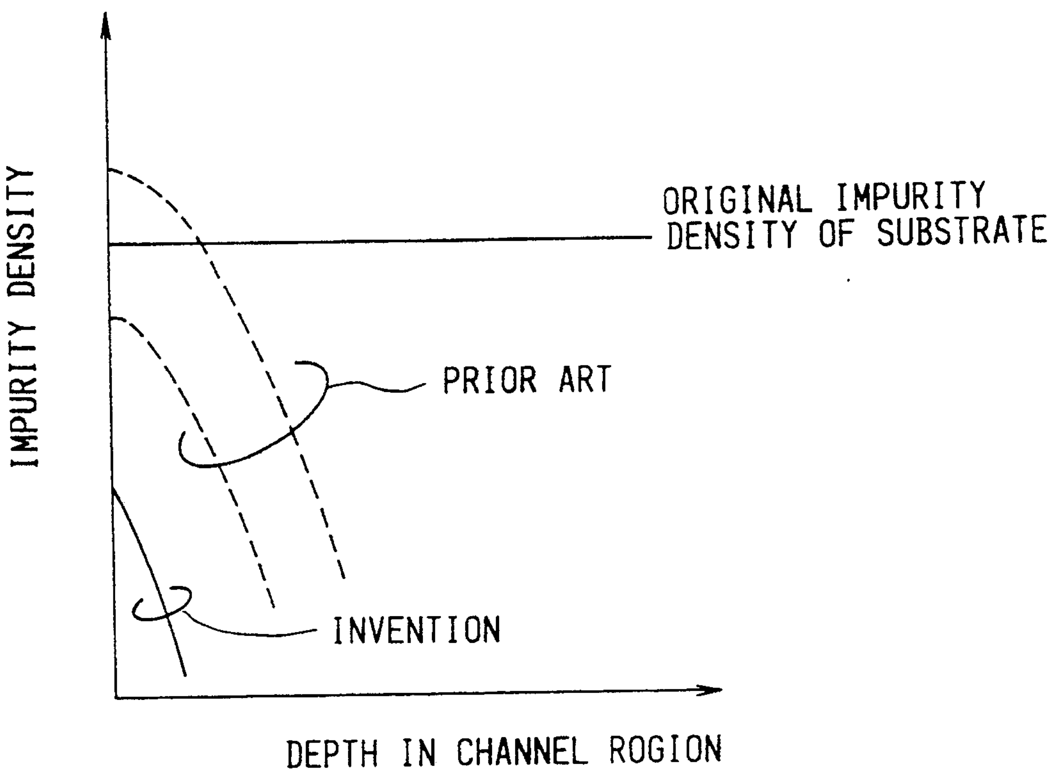
IMPURITY DENSITY
ORIGINAL IMPURITY
DENSITY OF SUBSTRATE
PRIOR ART
INVENTION
DEPTH IN CHANNEL ROGION